(19)

Europäisches Patentamt
European Patent Office
Office européen des brevets

(11) **EP 4 160 231 B1**

(12) **EUROPEAN PATENT SPECIFICATION**

(45) Date of publication and mention
of the grant of the patent:
**17.09.2025  Bulletin 2025/38**

(21) Application number: **21813092.0**

(22) Date of filing: **24.05.2021**

(51) International Patent Classification (IPC):
**G01R 31/28** *(2006.01)*      **G01R 31/317** *(2006.01)*

(52) Cooperative Patent Classification (CPC):
**G01R 31/31725; G01R 31/31727**

(86) International application number:
**PCT/CN2021/095395**

(87) International publication number:
**WO 2021/238829 (02.12.2021 Gazette 2021/48)**

(54) **METHOD AND CIRCUIT FOR MEASURING SETUP TIME OF TIMING  UNIT**

VERFAHREN UND SCHALTKREIS ZUR MESSUNG DER SETUP-ZEIT EINER TAKTEINHEIT

PROCÉDÉ  ET APPAREIL À MEASURER LE TEMPS DE RÉGLAGE D'UN UNITÉ DE SYNCHRONISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **29.05.2020   CN 202010478666**

(43) Date of publication of application:
**05.04.2023  Bulletin 2023/14**

(73) Proprietor: **Sanechips Technology Co., Ltd.
Shenzhen, Guangdong 518055 (CN)**

(72) Inventor: **PENG, Minqiang
Shenzhen, Guangdong 518057 (CN)**

(74) Representative: **Canzler & Bergmeier
Patentanwälte
Partnerschaft mbB
Despag-Straße 6
85055 Ingolstadt (DE)**

(56) References cited:
CN-A- 101 771 400       CN-A- 104 639 124
CN-A- 105 629 159       CN-A- 105 759 195
CN-A- 109 192 239       CN-A- 110 033 819
US-A1- 2001 014 851      US-A1- 2002 008 503
US-A1- 2002 008 503      US-A1- 2008 071 489
US-A1- 2009 323 447      US-A1- 2013 088 256

• **LUO ZHIHONG ET AL: "Self-Calibrate two-step digital setup/hold time measurement", VLSI DESIGN AUTOMATION AND TEST (VLSI-DAT), 2010 INTERNATIONAL SYMPOSIUM ON, IEEE, PISCATAWAY, NJ, USA, 26 April 2010 (2010-04-26), pages 232 - 235, XP031698617, ISBN: 978-1-4244-5269-9**

**Description**

TECHNICAL FIELD

The present application relates to the technical field of digital integrated circuits, and specifically relates to a method and a circuit for measuring setup time of a timing unit.

BACKGROUND

The setup time of the timing unit is one of the important factors that affect stable transmission of data signal. In design of a timing unit library, precision measurement of the setup time of timing units directly affects performance, production, and manufacture of a chip. The setup time is typically measured through clock phase fine adjustment, or using a plurality of buffers as a minimum measurement scale. However, these methods have many disadvantages, such as being limited by an adjustable range of the clock phase and a delay of the buffers, having differences in the measured clock path and data path, and even more obvious differences under different test voltages, thereby causing a large measurement error of the setup time of the timing unit.

US 2001/014851 A1 describes a method for determining a setup time of a flip-flop.

SUMMARY

An embodiment of present application provides a circuit for measuring setup time of a timing unit, including a clock signal generation module, a first selection module, a second selection module, a delay detection module, a data signal transmission module, a clock signal transmission module, a timing unit to be tested and a control module, where the clock signal generation module is respectively connected to the first selection module, the delay detection module and the control module; the delay detection module is respectively connected to the first selection module, the second selection module and the control module; the first selection module is respectively connected to the control module, the data signal transmission module and the clock signal transmission module; the second selection module is respectively connected to the control module, the data signal transmission module, and the clock signal transmission module; the data signal transmission module is respectively connected to the timing unit to be tested and the control module; the clock signal transmission module is respectively connected to the timing unit to be tested and the control module; and the timing unit to be tested is connected to the control module, the control module is configured to control the first selection module and the second selection module to form a first test path, a second test path and a third test path, respectively, so as to determine the setup time of the timing unit based on the first test path, the second test path and the third test path, where the first test path includes the clock signal generation module, the data signal transmission module, the clock signal transmission module, the timing unit to be tested and the control module, the second test path includes the clock signal generation module, the delay detection module, the data signal transmission module, and the control module, and the third test path includes the clock signal generation module, the delay detection module, the clock signal transmission module, and the control module.

An embodiment of the present application further provides a method for measuring setup time of a timing unit, which is applicable to the circuit for measuring setup time of a timing unit according to the embodiment of the present application, where the circuit includes a clock signal generation module, a first selection module, a second selection module, a delay detection module, a data signal transmission module, a clock signal transmission module, a timing unit to be tested and a control module, the control module controls the first selection module and the second selection module to form a first test path, a second test path and a third test path, respectively, the first test path includes the clock signal generation module, the data signal transmission module, the clock signal transmission module, the timing unit to be tested and the control module, the second test path includes the clock signal generation module, the delay detection module, the data signal transmission module, and the control module, and the third test path includes the clock signal generation module, the delay detection module, the clock signal transmission module, and the control module, and the method includes: respectively determining a first period value, a second period value and a third period value of a clock signal, where the first period value is a critical period of the clock signal when the timing unit to be tested is capable of correctly receiving a data signal at the first test path, the second period value is a critical period of the clock signal when the delay detection module is capable of correctly receiving a data signal at the second test path, and the third period value is a critical period of the clock signal when the delay detection module is capable of correctly receiving a data signal at the third test path; and determining the setup time of the timing unit according to the first period value, the second period value and the third period value.

With respect to the above embodiments and other aspects of the present application and implementations thereof, further description is provided in the brief description of drawings, the detailed description of embodiments, and the claims.

BRIEF DESCRIPTION OF DRAWINGS

FIG. 1 is a schematic diagram illustrating setup time of a timing unit in the related art;
FIG. 2 is a schematic structural diagram of a circuit for measuring setup time of a timing unit according to an embodiment of the present application;
FIG. 3 is another schematic structural diagram of a circuit for measuring setup time of a timing unit according to an embodiment of the present application;
FIG. 4 is a flowchart of a method for measuring setup time of a timing unit according to an embodiment of the present application;
FIG. 5 is a flowchart of a method for determining a period value of a clock signal according to an embodiment of the present application;
FIG. 6 is a flowchart of a method for determining N critical period test values according to an embodiment of the present application; and
FIG. 7 is a flowchart of a method for determining an estimated range of a critical period of a clock signal according to an embodiment of the present application.

DETAIL DESCRIPTION OF EMBODIMENTS

Embodiments of the present application will be described below with reference to the accompanying drawings.

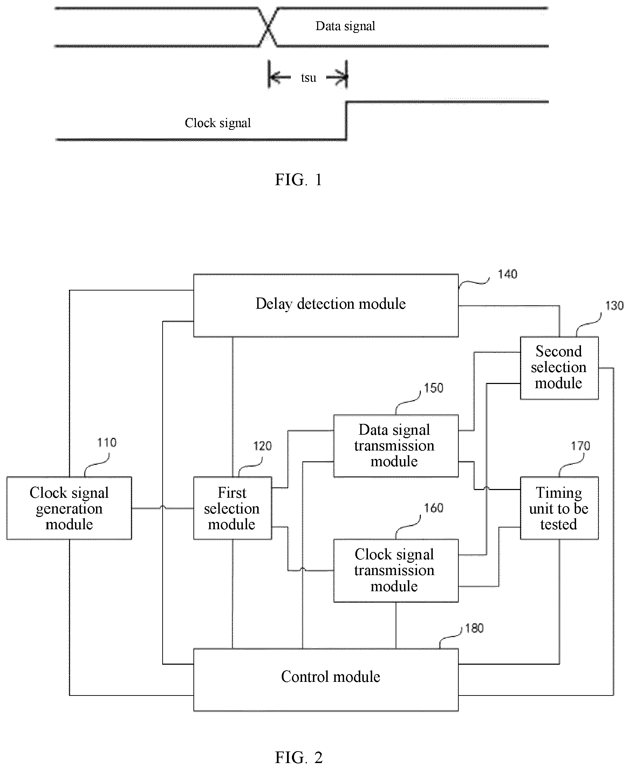

FIG. 1 is a schematic diagram illustrating setup time of a timing unit in the related art.
Referring to FIG. 1, the setup time (tsu) of a timing unit (e.g., a flip-flop) refers to the time that a data signal is desired to remain stable before a rising edge of a clock signal of the timing unit arrives. If there is no enough tsu, the data will not be able to be driven into the flip-flop on this clock rising edge stably. Therefore, the tsu refers to the minimum stabilization time.
In the related art, the setup time of the timing unit is obtained through simulation by a spice tool in design of a unit library. However, this is merely a theoretically calculated value. If the theoretically calculated value is greater than the actual value in the chip, unnecessary difficulties are added to back-end timing convergence; and if the theoretically calculated value is smaller, a timing problem may occur after the chip is produced, making the chip unable to reach the actual working frequency. Therefore, when the design of the timing unit library is completed, it is very important to maintain consistency between the theoretical value and the actual value of the setup time. In order to ensure consistency between the theoretical value and the actual value of the setup time, the setup time is usually desired to be tested and verified.
In a related technical solution, there is provided a method for measuring the setup time based on clock phase fine adjustment. For example, after the clock phase fine adjustment, two clocks with a phase deviation after the fine adjustment are respectively used as clocks and data to be sent to the timing unit to be tested for identification of setup violation, so as to determine the setup time of the timing unit. However, the precision of such measurement is limited by a minimum adjustable step of the clock phase, the clocks differ on different transmission paths, and such differences vary under different voltages, so that the measurement result may have a very large error.
**In** another related technical solution, it is proposed to use a buffer with a smaller delay as the minimum measurement scale, and construct different numbers of buffers for the clock path and the data path of the timing unit, so as to determine how many buffers of the minimum measurement scale the setup time is equivalent to. The precision of this method is limited by the delay of the buffer as the minimum measurement scale, there are also differences in the measured clock path and data path, and such differences are increased under different voltages, leading to a very large error in the measurement result.
In view of this, the present application provides a circuit and a method for measuring setup time of a timing unit. Firstly, a control module controls a first selection module and a second selection module to form a first test path, a second test path and a third test path, respectively. Then, a critical period (referred to a first period value) of a clock signal when a timing unit to be tested is capable of correctly receiving a data signal at the first test path, a critical period (referred to as a second period value) of the clock signal when a delay detection module is capable of correctly receiving a data signal at the second test path, and a critical period (referred to as a third period value) of the clock signal when the delay detection module is capable of correctly receiving a data signal at the third test path, are respectively determined. Finally, the setup time of the timing unit is determined according to the first period value, the second period value and the third period value. As can be seen, the setup time of the timing unit is determined merely according to the first period value, the second period value and the third period value, but not limited by the adjustable range of the clock phase and the delay of the buffers, which overcomes the problem of large measurement error caused by the differences under different test voltages, and improves the measurement precision.
FIG. 2 is a schematic structural diagram of a circuit for measuring setup time of a timing unit according to an embodiment of the present application.

Referring to FIG. 2, the circuit includes a clock signal generation module 110, a first selection module 120, a second selection module 130, a delay detection module 140, a data signal transmission module 150, a clock signal transmission module 160, a timing unit to be tested 170 and a control module 180.

The clock signal generation module 110 is respectively connected to the first selection module 120, the delay detection module 140 and the control module 180. The delay detection module 140 is respectively connected to the first selection module 120, the second selection module 130 and the control module 180. The first selection module 120 is respectively connected to the control module 180, the data signal transmission module 150 and the clock signal transmission module 160. The second selection module 130 is respectively connected to the control module 180, the data signal transmission module 150 and the clock signal transmission module 160. The data signal transmission module 150 is respectively connected to the timing unit to be tested 170 and the control module 180. The clock signal transmission module 160 is respectively connected to the timing unit to be tested 170 and the control module 180. The timing unit to be tested 170 is connected to the control module 180.

The control module 180 is configured to control the first selection module 120 and the second selection module 130 to form a first test path, a second test path and a third test path, respectively, so as to determine the setup time of the timing unit based on the first test path, the second test path and the third test path. The first test path includes the clock signal generation module 110, the data signal transmission module 150, the clock signal transmission module 160, the timing unit to be tested 170 and the control module 180. The second test path includes the clock signal generation module 110, the delay detection module 140, the data signal transmission module 150, and the control module 180. The third test path includes the clock signal generation module 110, the delay detection module 140, the clock signal transmission module 160, and the control module 180.

In an embodiment, the first selection module 120 is configured to control one of the clock signal generation module 110 or the delay detection module 140 to be connected to the data signal transmission module 150 and the clock signal transmission module 160, respectively. The second selection module 130 is configured to control one of the data signal transmission module 150 or the clock signal transmission module 160 to be connected to the delay detection module 140.

For example, when the control module 180 controls the first selection module 120 to control the clock signal generation module 110 to be connected to the data signal transmission module 150 and the clock signal transmission module 160, respectively, the test circuit enters a critical point test mode of the setup time of the timing unit to be tested 170, in which the first test path including the clock signal generation module 110, the data signal transmission module 150, the clock signal transmission module 160, the timing unit to be tested 170, and the control module 180 is formed.

For example, when the control module 180 controls the first selection module 120 to control the delay detection module 140 to be connected to the data signal transmission module 150 and the clock signal transmission module 160, respectively, and controls the second selection module 130 to control one of the data signal transmission module 150 or the clock signal transmission module 160 to be connected to the delay detection module 140, the test circuit enters a delay comparison mode of the clock signal transmission path and the data signal transmission path. The data signal transmission path is the second test path including the clock signal generation module 110, the delay detection module 140, the data signal transmission module 150, and the control module 180, and the clock signal transmission path is the third test path including the clock signal generation module 110, the delay detection module 140, the clock signal transmission module 160, and the control module 180.

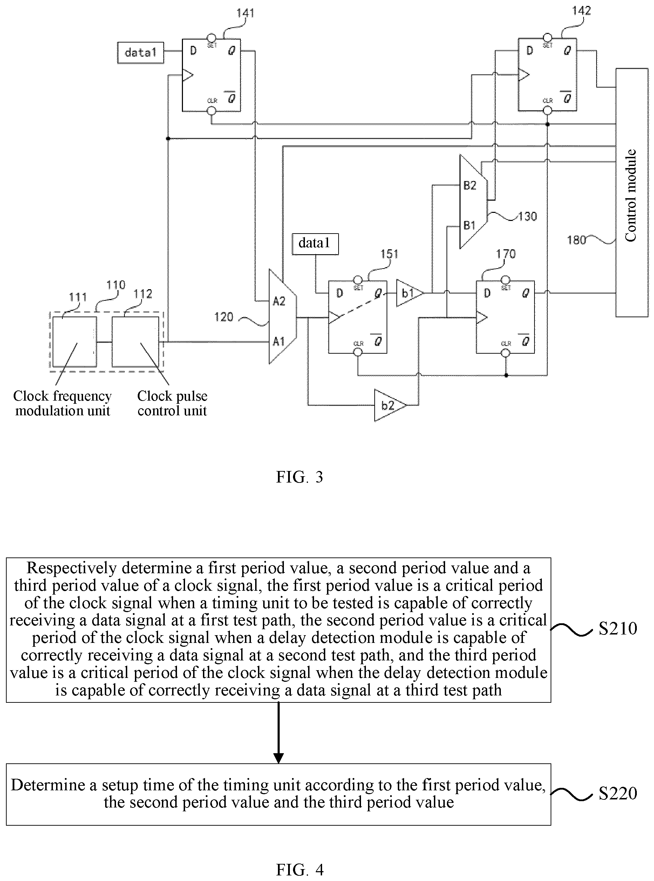

FIG. 3 is another schematic structural diagram of a circuit for measuring setup time of a timing unit according to an embodiment of the present application.

Referring to FIGs. 2 and 3, the clock signal generation module 110 includes a clock frequency modulation unit 111 and a clock pulse control unit 112. The clock frequency modulation unit 111 is connected to the clock pulse control unit 112, the clock pulse control unit 112 is respectively connected to the delay detection module 140 (shown as a first launch register 141 and a capture register 142 in FIG. 3) and a first input end A1 of the first selection module 120, and the control module 180 is respectively connected to the clock frequency modulation unit 111 and the clock pulse control unit 112.

In an embodiment, the clock frequency modulation unit 111 may be a phase lock loop (PLL) used as a clock source, which has a higher clock frequency precision, higher stability, smaller jitter, and can be finely adjusted. The clock pulse control unit 112 may be an on-chip-clock (OCC) configured to output a clock pulse signal.

In an embodiment, the delay detection module 140 includes a first launch register 141 and a capture register 142. A first input end of the first launch register 141 is connected to the clock signal generation module 110, a second input end of the first launch register 141 is connected to an external data signal data1, and an output end of the first launch register 141 is connected to a second input end A2 of the first selection module 120. A first input end of the capture register 142 is connected to the clock signal generation module 110, a second input end of the capture register 142 is connected to an output end of the second selection module 130, and an output end of the capture register 142 is connected to the control module 180.

In an embodiment, the test circuit is at the second test path and the third test path, the first launch register 141 serves as a start point of data signal transmission, and the capture register 142 serves as an end point of data signal transmission. For example, at the second test path, the control module 180 controls the second input end A2 of the first selection module 120 to be turned on, i.e., controls the output end of the first launch register 141 of the delay detection module 140 to be respectively connected to the data signal transmission module 150 (shown as a second launch register 151 and a first buffer module b1 in FIG. 3) and the clock signal transmission module 160 (shown as a second buffer module b2 in FIG. 3). The control module 180 further controls a second input end B2 of the second selection module 130 to be connected to the capture register 142 of the delay detection module 140, i.e., controls to form the second test path including the clock signal generation module 110, the first launch register 141, the data signal transmission module 150, the capture register 142, and the control module 180. During testing at the second test path, a clock signal output from the clock signal generation module 110 is input to the first input end of the first launch register 141, and the external data signal data1 is input to the second input end of the first launch register 141, output from the first launch register 141, and transmitted to the capture register 142 via the data signal transmission module 150. For example, at the third test path, the control module 180 controls the second input end A2 of the first selection module 120 to be turned on, i.e., controls the output end of the first launch register 141 of the delay detection module 140 be connected to the data signal transmission module 150 and the clock signal transmission module 160, respectively. The control module 180 further controls a first input end B1 of the second selection module 130 to be connected to the capture register 142 of the delay detection module 140, i.e., controls to form the third test path including the clock signal generation module 110, the first launch register 141, the clock signal transmission module 160, the capture register 142, and the control module 180. During testing at the third test path, the clock signal output from the clock signal generation module 110 is input to the first input end of the first launch register 141, and the external data signal data1 is input to the second input end of the first launch register 141, output from the first launch register 141, and transmitted to the capture register 142 via the clock signal transmission module 160.

In an embodiment, the data signal transmission module 150 includes the second launch register 151. A first input end of the second launch register 151 is connected to the output end of the first selection module 120, a second input end of the second launch register 151 is connected to the external data signal data1, and an output end of the second launch register 151 is respectively connected to the second input end B2 of the second selection module 130 and a second input end of the timing unit to be tested 170.

In an embodiment, the external data signal data1 input at the second input end of the second launch register 151 is configured to provide a data signal for testing at the first test path test. For example, at the first test path, the control module 180 controls the first input end A1 of the first selection module 120 to be turned on, i.e., controls the output end of the clock signal generation module 110 to be respectively connected to the data signal transmission module 150 and the clock signal transmission module 160, so as to form the first test path including the clock signal generation module 110, the data signal transmission module 150, the clock signal transmission module 160, the timing unit to be tested 170, and the control module 180. During testing at the first test path, the clock signal output from the clock signal generation module 110 is input to the first input end of the second launch register 151, and the external data signal data1 is input to the second input end of the second launch register 151, output from the second launch register 151, and then transmitted to the timing unit to be tested 170.

In an embodiment, a reset end of the second launch register 151, a reset end of the first launch register 141, a reset end of the capture register 142, and a reset end of the timing unit to be tested 170 are respectively connected to the control module 180. Via the control module 180, reset and clear functions of the second launch register 151, the first launch register 141, the capture register 142, and the timing unit to be tested 170 can be controlled.

In an embodiment, the data signal transmission module 150 further includes the first buffer module b1. An input end of the first buffer module b1 is connected to the output end of the second launch register 151, an output end of the first buffer module b1 is respectively connected to the second input end B2 of the second selection module 130 and the second input end of the timing unit to be tested 170. The clock signal transmission module 160 includes the second buffer module b2. An input end of the second buffer module b2 is connected to the output end of the first selection module 120, and an output end of the second buffer module b2 is respectively connected to a first input end B1 of the second selection module 130 and a first input end of the timing unit to be tested 170.

In an embodiment, the second launch register 151 and the first buffer module b1 form a data signal transmission path, and the first buffer module b1 is used to adjust a delay time of the data transmission module 150. The second buffer module b2 forms the clock signal transmission path, and is configured to adjust the delay time of the clock signal transmission module 160. It should be noted that a plurality of first buffer modules b1 for the data signal transmission path may be provided, and also a plurality of second buffer modules b2 for the clock signal transmission path may be provided. The specific number of the first buffer modules b1 and the specific number of the second buffer modules b2 may be set according to the actual testing requirements, which are not specifically limited in the present application.

In an embodiment, when the control module 180 controls the first input end A1 of the first selection module 120 to be closed (turned on) and the second input end A2 to be opened (turned off), and the first input end B1 and the second input end B2 of the second selection module 130 to be both opened, the first test path is formed. When the control module 180 controls the first input end A1 of the first selection module 120 to be opened and the second input end A2 to be closed, and the first input end B1 of the second selection module 130 to be opened and the second input end B2 to be closed, the second test path is formed. When the control module 180 controls the first input end A1 of the first selection module 120 to be opened and the second input end A2 to be closed, and the first input end B1 of the second selection module 130 to be closed and the second input end B2 to be opened, the third test path is formed.

In an embodiment, when the control module 180 controls the first input end A1 of the first selection module 120 to be closed and the second input end A2 to be opened, and the first input end B1 and the second input end B2 of the second selection module 130 to be both opened, the delay detection module 140 is disconnected from the data signal transmission module 150 and the clock signal transmission module 160, and the output end of the clock signal generation module 110 is respectively connected to the data signal transmission module 150 and the clock signal transmission module 160, thereby forming the first test path including the clock signal generation module 110, the data signal transmission module 150 (including the data signal transmission path formed by the second launch register 151 and the first buffer module b1), the clock signal transmission module 160 (including the clock signal transmission path formed by the second buffer module b2), the timing unit to be tested 170, and the control module 180. In the first test path, the data signal transmission path has a fixed delay, denoted as $T_{data}$, and the clock signal transmission path also has a fixed delay, denoted as $T_{clk}$. During testing at the first test path, the clock signal output from the clock signal generation module 110 is input to the first input end of the second launch register 151, and the external data signal data1 is input to the second input end of the second launch register 151, and a frequency of the clock signal can be adjusted via the clock signal generation module 110. Generally, in the case of a relatively low clock signal frequency, the external data signal data1 output from the second launch register 151 can be obtained by the timing unit to be tested 170. However, when the clock signal frequency reaches a certain threshold, setup violation will occur, and the timing unit to be tested 170 cannot obtain the external data signal data1 output from the second launch register 151. The period of the clock signal at which the setup violation occurs (i.e., the critical period) is denoted as Period_su, which satisfies:

$$T_{data} - T_{clk} = Period\_su - T_{su}$$

where $T_{su}$ is the setup time of the timing unit to be tested 170.

In an embodiment, when the control module 180 controls the first input end A1 of the first selection module 120 to be opened and the second input end A2 to be closed, and the first input end B1 of the second selection module 130 to be opened and the second input end B2 to be closed, the first launch register 141 is connected to the data signal transmission module 150 (including the data signal transmission path formed by the second launch register 151 and the first buffer module b1), and the data signal transmission module 150 is connected to the capture register 142, thereby forming the second test path including the clock signal generation module 110, the first launch register 141, the second launch register 151, the first buffer module b1, the capture register 142, and the control module 180. During testing at the second test path, the clock signal output from the clock signal generation module 110 is input to the first input end of the first launch register 141, and the external data signal data1 is input to the second input end of the first launch register 141, and the frequency of the clock signal can be adjusted via the clock signal generation module 110. Generally, in the case of a relatively low clock signal frequency, the external data signal data1 output from the first launch register 141 can be obtained by the capture register 142 via the second launch register 151 and the first buffer module b1, and in the case of a relatively high clock signal frequency, the transmission speed of the data signal can be increased. However, if the clock signal frequency is too high, the capture register 142 cannot obtain the external data signal data1 output from the first launch register 141. The period of the clock signal (i.e., the critical period) at which the clock signal frequency reaches a value such that the capture register 142 can just obtain the external data signal data1 is denoted as Period_data.

In an embodiment, when the control module 180 controls the first input end A1 of the first selection module 120 to be opened and the second input end A2 to be closed, and the first input end B1 of the second selection module 130 to be closed and the second input end B2 to be opened, the first launch register 141 is connected to the clock signal transmission module 160 (including the data signal transmission path formed by the second buffer module b2), and the clock signal transmission module 160 is connected to the capture register 142, thereby forming the third test path including the clock signal generation module 110, the first launch register 141, the second buffer module b2, the capture register 142, and the control module 180. During testing at the third test path, the clock signal output from the clock signal generation module 110 is input to the first input end of the first launch register 141, and the external data signal data1 is input to the second input end of the first launch register 141, and the frequency of the clock signal can be adjusted via the clock signal generation module 110. Generally, in the case of a relatively low clock signal frequency, the external data signal data1 output from the first launch register 141 can be obtained by the capture register 142 via the second buffer module b2, and in the case of a relatively high clock signal frequency, the transmission speed of the data signal can be increased. However, if the clock signal frequency is too high, the capture register 142 cannot obtain the external data signal data1 output from the first launch register 141. The period of the clock signal (i.e., the critical period) at which the clock signal frequency reaches a value such that the capture register 142 can just obtain the external data signal data1 is denoted as Period_clk.

The critical period Period_data at the second test path and the critical period Period_clk at the third test path satisfy:

$$T_{data} - T_{clk} = Period\_data - Period\_clk$$

Combining the condition satisfied by the critical period Period_su of the clock signal when setup violation occurs at the first test path, it can be obtained that:

$$T_{su} = Period\_su - \left(Period\_data - Period\_clk\right)$$

After transformation, it can be obtained that:

$$T_{su} = Period\_su + Period\_clk - Period\_data$$

As can be seen, the setup time $T_{su}$ of the timing unit is related merely to the critical pepriod Period_su of the clock signal when setup violation occurs in the timing unit to be tested 170 at the first test path, the critical period Period_data of the clock signal when the delay detection module 140 can just obtain the external data signal data1 at the second test path, and the critical period Period_clk of the clock signal when the delay detection module 140 can just obtain the external data signal data1 at the third test path, but is independent of the differences of the data signal transmission path and the clock signal transmission path, the delay of the buffers or the test voltages. Therefore, the problem of a large measurement result error caused by the differences of the data signal transmission path and the clock signal transmission path, the delay of the buffers and the differences under different test voltages can be solved, thereby improving the measurement precision of the setup time of the timing unit to be tested 170.

FIG. 4 is a flowchart of a method for measuring setup time of a timing unit according to an embodiment of the present application. The method for measuring setup time of a timing unit of the present application is suitable for the circuit for measuring setup time of a timing unit according to the embodiments of the present application. The circuit includes a clock signal generation module, a first selection module, a second selection module, a delay detection module, a data signal transmission module, a clock signal transmission module, a timing unit to be tested and a control module. The control module controls the first selection module and the second selection module to form a first test path, a second test path and a third test path, respectively. The first test path includes the clock signal generation module, the data signal transmission module, the clock signal transmission module, the timing unit to be tested and the control module. The second test path includes the clock signal generation module, the delay detection module, the data signal transmission module, and the control module. The third test path includes the clock signal generation module, the delay detection module, the clock signal transmission module, and the control module.

Referring to FIG. 4, the method for measuring setup time of a timing unit according to an embodiment of the present application includes the following operations S210 to S220.

At operation S210, respectively determining a first period value, a second period value and a third period value of a clock signal, where the first period value is a critical period of the clock signal when the timing unit to be tested is capable of correctly receiving a data signal at the first test path, the second period value is a critical period of the clock signal when the delay detection module is capable of correctly receiving a data signal at the second test path, and the third period value is a critical period of the clock signal when the delay detection module is capable of correctly receiving a data signal at the third test path.

At operation S220, determining the setup time of the timing unit according to the first period value, the second period value and the third period value.

In an embodiment, the setup time of the timing unit is equal to a difference between the first period value and a difference between the second period value and the third period value, i.e., the setup time of the timing unit = first period value - (second period value - third period value). After transformation, it can be obtained that the setup time of the timing unit is equal to a difference obtained by a sum of the first period value and the third period value minus the second period value, i.e., the setup time of the timing unit = first period value + third period value - second period value.

In an embodiment, a period or frequency of the clock signal output from the clock signal generation module 110 may be controlled by the control module 180, to adjust the frequency of the clock signal at the first test path, the second test path, and the third test path.

In an embodiment, at the first test path, when setup violation occurs in the timing unit to be tested 170, that is, when the timing unit to be tested 170 can just obtain an external data signal data1 output from the second launch register 151 of the data signal transmission module 150, the measured period value of the clock signal is the first period value Period_su. At the second test path, when the capture register 142 can just obtain the external data signal data1 output from the first launch register 141 of the delay detection module 140 via the data signal transmission module 150, the measured period value of the clock signal is the second period value Period_data. At the third test path, when the capture register 142 can just obtain the external data signal data1 output from the first launch register 141 of the delay detection module 140 via the clock signal transmission module 160, the measured period value of the clock signal is the third period value Period_clk. The first period value, the second period value, the third period value and the setup time $T_{su}$ of the timing unit to be tested 170 satisfy:

$$T_{su} = Period\_su - \left( Period\_data - Period\_clk \right)$$

After transformation, it can be obtained that:

$$T_{su} = Period\_su + Period\_clk - Period\_data$$

Thereby, the setup time $T_{su}$ of the timing unit to be tested 170 can be determined.

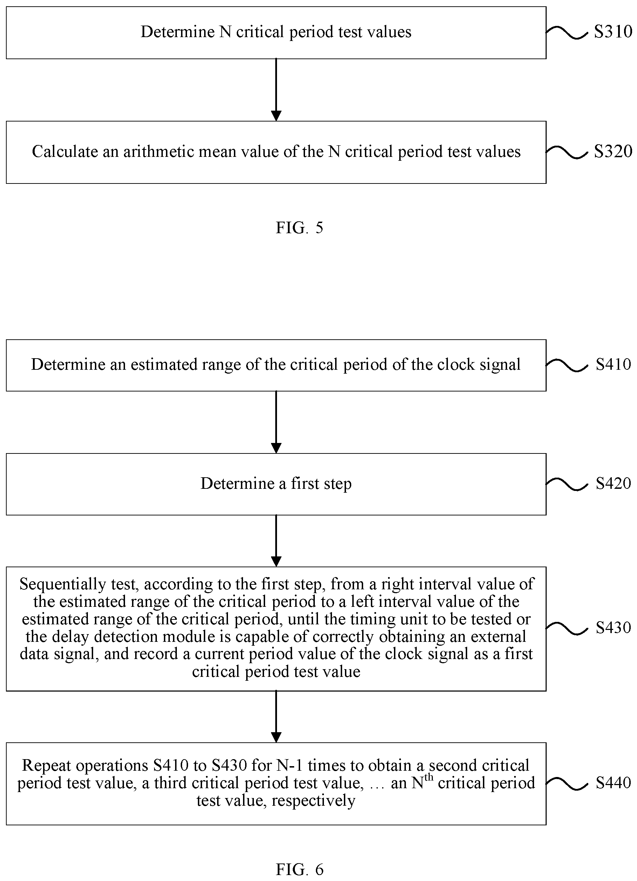

FIG. 5 is a flowchart of a method for determining a period value of a clock signal according to an embodiment of the present application.

The period value of the clock signal can be determined according to the method illustrated in FIG. 5. The period value may be any one of the first period value, the second period value, or the third period value. As shown in FIG. 5, the method for determining the period value of the clock signal includes the following operations S310 to S320

At operation S310, determining N critical period test values.

At operation S320, calculating an arithmetic mean value of the N critical period test values.

In an embodiment, the process of determining the first period value may include: at the first test path, when setup violation occurs in the timing unit to be tested 170, that is, when the timing unit to be tested 170 can just obtain the external data signal data1 output from the second launch register 151 of the data signal transmission module 150, testing a period value of the clock signal to obtain a critical period test value Period_su_trigger_1; repeating the testing for N-1 times to obtain N critical period test values Period_su_trigger_1 to Period_su_trigger_N corresponding to the first period value; and calculating an arithmetic mean value of the N critical period test values to obtain the first period value. The expression is:

$$Period\_su\_avg = \frac{1}{N} \sum_{i=1}^{N} Period\_su\_trigger\_i$$

where Period_su_trigger_i is a critical period test value corresponding to the first period value measured in an $i^{th}$ test experiment, and Period_su_avg is an arithmetic mean value of the critical period test values measured in the N test experiments.

In an embodiment, the process of determining the second period value may include: at the second test path, when the capture register 142 can just obtain the external data signal data1 output from the first launch register 141 of the delay detection module 140 via the data signal transmission module 150, testing a period value of the clock signal to obtain a critical period test value Period_data_trigger_1; repeating the testing for N-1 times to obtain N critical period test values Period_data_trigger_1 to Period_data_trigger_N corresponding to the second period value; and calculating an arithmetic mean value of the N critical period test values to obtain the second period value. The expression is:

$$Period\_data\_avg = \frac{1}{N} \sum_{i=1}^{N} Period\_data\_trigger\_i$$

where Period_data_trigger_i is a critical period test value corresponding to the second period value measured in an $i^{th}$ test experiment, and Period_data_avg is an arithmetic mean value of the critical period test values measured in the N test experiments.

In an embodiment, the process of determining the third period value may include: at the third test path, when the capture register 142 can just obtain the external data signal data1 output from the first launch register 141 of the delay detection module 140 via the clock signal transmission module 160, testing a period value of the clock signal to obtain a critical period test value Period_clk_trigger_1; repeating the testing for N-1 times to obtain N critical period test values Period_clk_trigger_1 to Period_clk_trigger_N corresponding to the third period value; and calculating an arithmetic mean value of the N critical period test values to obtain the third period value. The expression is:

$$Period\_clk\_avg = \frac{1}{N}\sum_{i=1}^{N}Period\_clk\_trigger\_i$$

where Period_clk_trigger_i is a critical period test value corresponding to the third period value measured in an $i^{th}$ test experiment, and Period_clk_avg is an arithmetic mean value of the critical period test values measured in the N test experiments.

FIG. 6 is a flowchart of a method for determining N critical period test values according to an embodiment of the present application.

Referring to FIG. 6, the method for determining N critical period test values includes the following operations S410 to S440.

At operation S410, determining an estimated range of the critical period of the clock signal.

At operation S420, determining a first step.

At operation S430, sequentially testing, according to the first step, from a right interval value of the estimated range of the critical period to a left interval value of the estimated range of the critical period, until the timing unit to be tested or the delay detection module is capable of correctly obtaining the external data signal, and recording a current period value of the clock signal as a first critical period test value.

At operation S440, repeating operations S410 to S430 for N-1 times to obtain a second critical period test value, a third critical period test value, ... an $N^{th}$ critical period test value, respectively.

In an embodiment, taking the process of determining N critical period test values corresponding to the first cycle value as an example, the process of determining N critical period test values may include: at the first test path, in the case where the clock signal generation module 110 outputs a clock signal at a certain clock frequency, adjusting the frequency of the clock signal, testing setup violation conditions of the timing unit to be tested 170 at different clock frequencies, recording a frequency or period of the clock signal when setup violation occurs in the timing unit to be tested 170, and finding an approximate range of the critical period of the clock signal when setup violation occurs in the timing unit to be tested 170, where an estimated range F of the critical period is denoted as <Period_gross - step_p, Period_gross + step_p>. Then, a first step, step1, is determined, and the period of the clock signal output from the clock signal generation module 110 is changed by the control module 180, and setup violation conditions of the timing unit to be tested 170 in different periods are tested. According to the first step step1, testing may be performed by sequentially changing the period of the clock signal from a right interval value Period_gross + step_p of the estimated range F of the critical period to a left interval value Period_gross - step_p of the estimated range F of the critical period, until the timing unit to be tested 170 is capable of correctly obtaining the external data signal, and a current period value of the clock signal is recorded as a first critical period test value. Then, the above process is repeated for N-1 times to obtain a second critical period test value, a third critical period test value, ... an $N^{th}$ critical period test value, respectively. In a similar method as described above, N critical period test values corresponding to the second period value, and N critical period test values corresponding to the third period value, can be obtained.

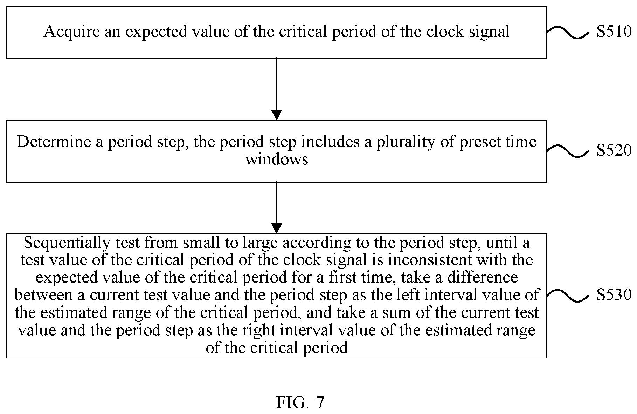

FIG. 7 is a flowchart of a method for determining an estimated range of a critical period of a clock signal according to an embodiment of the present application.

Referring to FIG. 7, the method for determining the estimated range of the critical period of the clock signal includes the following operations S510 to S530.

At operation S510, acquiring an expected value of the critical period of the clock signal.

At operation S520, determining a period step, where the period step includes a plurality of preset time windows.

At operation S530, sequentially testing from small to large according to the period step, until a test value of a critical period of the clock signal is inconsistent with the expected value of the critical period for a first time, taking a difference between the current test value and the period step as the left interval value of the estimated range of the critical period, and taking a sum of the current test value and the period step as the right interval value of the estimated range of the critical period.

In an embodiment, taking the process of determining the estimated range of the critical period of the clock signal corresponding to the first period value as an example, the process of determining the estimated range of the critical period of the clock signal may include: first, acquiring an expected value of the critical period of the clock signal through theoretical calculation (e.g., through simulation by a spice tool); then determining a period step step2, where the period step step2 is variable and includes a plurality of preset time windows of different periods (for example, a plurality of durations, such as T1, T2, and T3 ... Tn, of different lengths); and finally, changing the period of the clock signal output from the clock signal generation module 110 by the control module 180, and, at the first test path, testing the critical period of the clock signal when setup violation occurs in the timing unit to be tested 170 in a corresponding period of the clock signal. The period of the clock signal may be sequentially changed according to the preset time windows of the period step step2 from small to large, and the testing is performed respectively, until a test value of a critical period of the clock signal is inconsistent with the expected value of the critical period for a first time. A difference between the current test value and the period step is taken as the left interval value of the estimated range of the critical period, and a sum of the current test value and the period step is taken as the right interval value of the estimated range of the critical period. In a similar method as described above, the estimated range of the critical period of the clock signal corresponding to the second period value and the estimated range of the critical period of the clock signal corresponding to the third period value can be obtained.

**In** an embodiment, the first step step1 may be determined according to a length of time that the clock signal is jittered.

Generally, the clock signal generated by a clock source has a jitter, and due to different masses of the clock source, there is a great difference in the magnitude of the jitter, which may affect determination of the first period value, the second period value and the third period value of the clock signal. **In** order to eliminate or minimize the effect of the clock jitter on the precision of the measurement result, the first step step1 may be determined according to a length of time that the clock signal is jittered. Assuming that a duration of the clock signal jitter is T_jitter, then the first step step1 may be determined by:

$$step1 = {T\_jitter}/{M}$$

where M is an integer, and the larger the value of M, the smaller the first step step1, the higher the precision of the adjustment, and the better the effect of reducing the jitter influence.

The above are only exemplary embodiments of the present application and not intended to limit the scope of the present application.

The foregoing has provided by way of exemplary and non-limiting examples a detailed description of exemplary embodiments of the present application. Accordingly, the scope of the invention is determined by the appended claims.

## Claims

1.  A method for measuring setup time of a timing unit, which is applicable to a circuit for measuring setup time of a timing unit, wherein the circuit comprises a clock signal generation module (110), a first selection module (120), a second selection module (130), a delay detection module (140), a data signal transmission module (150), a clock signal transmission module (160), a timing unit to be tested (170) and a control module (180), the control module controls the first selection module and the second selection module to form a first test path, a second test path and a third test path, respectively, the first test path comprises the clock signal generation module, the data signal transmission module, the clock signal transmission module, the timing unit to be tested and the control module, the second test path comprises the clock signal generation module, the delay detection module, the data signal transmission module, and the control module, and the third test path comprises the clock signal generation module, the delay detection module, the clock signal transmission module, and the control module; and
    the method comprises:

    respectively determining (S210) a first period value, a second period value and a third period value of a clock signal, wherein the first period value is a critical period of the clock signal when the timing unit to be tested is capable of correctly receiving a data signal at the first test path, the second period value is a critical period of the clock signal when the delay detection module is capable of correctly receiving a data signal at the second test path, and the third period value is a critical period of the clock signal when the delay detection module is capable of correctly receiving a data signal at the third test path; and
    determining (S220) the setup time of the timing unit according to the first period value, the second period value and the third period value.

2.  The method for measuring setup time of a timing unit according to claim 1, wherein the setup time of the timing unit is equal to a difference obtained by a sum of the first period value and the third period value minus the second period value.

3.  The method for measuring setup time of a timing unit according to claim 1, wherein determining any one of the first period value, the second period value, or the third period value of the clock signal comprises:

    determining (S310) N critical period test values; and
    calculating (S320) an arithmetic mean value of the N critical period test values.

4. The method for measuring setup time of a timing unit according to claim 3, wherein determining the N critical period test values comprises:

S1: determining (S410) an estimated range of the critical period of the clock signal;
S2: determining (S420) a first step;
S3: sequentially testing (S430), according to the first step, from a right interval value of the estimated range of the critical period to a left interval value of the estimated range of the critical period, until the timing unit to be tested or the delay detection module is capable of correctly obtaining the data signal, and recording a current period value of the clock signal as a first critical period test value;
repeating (S440) operations S1 to S3 for N-1 times to obtain a second critical period test value, a third critical period test value, ... an $N^{th}$ critical period test value, respectively.

5. The method for measuring setup time of a timing unit according to claim 4, wherein determining the estimated range of the critical period of the clock signal comprises:

acquiring (S510) an expected value of the critical period of the clock signal;
determining (S520) a period step, wherein the period step comprises a plurality of preset time windows; and sequentially testing (S530) from small to large according to the period step, until a test value of a critical period of the clock signal is inconsistent with the expected value of the critical period for a first time, taking a difference between the current test value and the period step as the left interval value of the estimated range of the critical period, and taking a sum of the current test value and the period step as the right interval value of the estimated range of the critical period.

6. The method for measuring setup time of a timing unit according to claim 4, wherein the first step is determined according to a length of time that the clock signal is jittered.

7. A circuit for measuring setup time of a timing unit, comprising a clock signal generation module (110), a first selection module (120), a second selection module (130), a delay detection module (140), a data signal transmission module (150), a clock signal transmission module (160), a timing unit to be tested (170) and a control module (180),

wherein the clock signal generation module (110) is respectively connected to the first selection module (120), the delay detection module (140) and the control module (180); the delay detection module (140) is respectively connected to the first selection module (120), the second selection module (120) and the control module (180); the first selection module (120) is respectively connected to the control module (180), the data signal transmission module (150) and the clock signal transmission module (160); the second selection module (130) is respectively connected to the control module (180), the data signal transmission module (150), and the clock signal transmission module (160); the data signal transmission module (150) is respectively connected to the timing unit to be tested (170) and the control module (180); the clock signal transmission module (160) is respectively connected to the timing unit to be tested (170) and the control module (180); and the timing unit to be tested (170) is connected to the control module (180),
the control module (180) is configured to control the first selection module (120) and the second selection module (130) to form a first test path, a second test path and a third test path, respectively, so as to determine the setup time of the timing unit based on the first test path, the second test path and the third test path,
wherein the first test path comprises the clock signal generation module (110), the data signal transmission module (150), the clock signal transmission module (160), the timing unit to be tested (170) and the control module (180), the second test path comprises the clock signal generation module (110), the delay detection module (140), the data signal transmission module (150), and the control module (160), and the third test path comprises the clock signal generation module (110), the delay detection module (140), the clock signal transmission module (160), and the control module (180).

8. The circuit for measuring setup time of a timing unit according to claim 7, wherein the clock signal generation module (110) comprises a clock frequency modulation unit (111) and a clock pulse control unit (112), the clock frequency modulation unit (111) is connected to the clock pulse control unit (112), the clock pulse control unit (112) is respectively connected to the delay detection module (140) and a first input end (A1) of the first selection module (120), and the control module (180) is respectively connected to the clock frequency modulation unit (111) and the clock pulse control unit (112).

9. The circuit for measuring setup time of a timing unit according to claim 7, wherein the delay detection module (140) comprises a first launch register (141) and a capture register (142), a first input end of the first launch register (141) is connected to the clock signal generation module (110), a second input end of the first launch register (141) is connected to an external data signal, and an output end of the first launch register (141) is connected to a second input end (A2) of the first selection module (120),

a first input end of the capture register (142) is connected to the clock signal generation module (110), a second input end of the capture register (142) is connected to an output end of the second selection module (130), and an output end of the capture register (142) is connected to the control module (180).

10. The circuit for measuring setup time of a timing unit according to claim 7, wherein the data signal transmission module (150) comprises a second launch register (151), a first input end of the second launch register (151) is connected to the output end of the first selection module (120), a second input end of the second launch register (151) is connected to an external data signal, and an output end of the second launch register (151) is respectively connected to a second input end (B2) of the second selection module (130) and a second input end of the timing unit to be tested (170).

11. The circuit for measuring setup time of a timing unit according to claim 10, wherein the data signal transmission module (150) further comprises a first buffer module (b1), an input end of the first buffer module (b1) is connected to the output end of the second launch register (151), and an output end of the first buffer module (b1) is respectively connected to the second input end (B2) of the second selection module (130) and the second input end of the timing unit to be tested (170).

12. The circuit for measuring setup time of a timing unit according to claim 7, wherein the clock signal transmission module (160) comprises a second buffer module (b2), an input end of the second buffer module (b2) is connected to the output end of the first selection module (120), and an output end of the second buffer module (b2) is respectively connected to a first input end (B1) of the second selection module (130) and a first input end of the timing unit to be tested (170).

13. The circuit for measuring setup time of a timing unit according to claim 7, wherein

in response to that the control module (180) controls a first input end (A1) of the first selection module (120) to be closed and a second input end (A2) to be opened, and a first input end (B1) and a second input end (B2) of the second selection module (130) to be both opened, the first test path is formed;
in response to that the control module (180) controls the first input end (A1) of the first selection module (120) to be opened and the second input end (A2) to be closed, and the first input end (B1) of the second selection module (130) to be opened and the second input end (B2) to be closed, the second test path is formed; and
in response to that the control module (180) controls the first input end (A1) of the first selection module (120) to be opened and the second input end (A2) to be closed, and the first input end (B1) of the second selection module (130) to be closed and the second input end (B2) to be opened, the third test path is formed.

**Patentansprüche**

1. Verfahren zum Messen der Einrichtungszeit einer Zeitsteuerungseinheit, das auf einen Schaltkreis zum Messen der Einrichtungszeit einer Zeitsteuerungseinheit anwendbar ist, wobei der Schaltkreis ein Taktsignal-Erzeugungsmodul (110), ein erstes Auswahlmodul (120), ein zweites Auswahlmodul (130), ein Verzögerungsdetektionsmodul (140), ein Datensignal-Übertragungsmodul (150), ein Taktsignal-Übertragungsmodul (160), eine zu testende Zeitsteuerungseinheit (170) und ein Steuermodul (180) umfasst, wobei das Steuermodul das erste Auswahlmodul und das zweite Auswahlmodul steuert, um einen ersten Testpfad, einen zweiten Testpfad bzw. einen dritten Testpfad zu bilden, wobei der erste Testpfad das Taktsignal-Erzeugungsmodul, das Datensignal-Übertragungsmodul, das Taktsignal-Übertragungsmodul, die zu testende Zeitsteuerungseinheit und das Steuermodul umfasst, der zweite Testpfad das Taktsignal-Erzeugungsmodul, das Verzögerungsdetektionsmodul, das Datensignal-Übertragungsmodul und das Steuermodul umfasst und der dritte Testpfad das Taktsignal-Erzeugungsmodul, das Verzögerungsdetektionsmodul, das Taktsignal-Übertragungsmodul und das Steuermodul umfasst; und
das Verfahren Folgendes umfasst:

jeweiliges Bestimmen (S210) eines ersten Zeitraumwerts, eines zweiten Zeitraumwerts und eines dritten Zeitraumwerts eines Taktsignals, wobei der erste Zeitraumwert ein kritischer Zeitraum des Taktsignals ist, wenn die zu testende Zeitsteuerungseinheit in der Lage ist, ein Datensignal auf dem ersten Testpfad korrekt zu empfangen, der zweite Zeitraumwert ein kritischer Zeitraum des Taktsignals ist, wenn das Verzögerungsdetektionsmodul in der Lage ist, ein Datensignal auf dem zweiten Testpfad korrekt zu empfangen, und der dritte Zeitraumwert ein kritischer Zeitraum des Taktsignals ist, wenn das Verzögerungsdetektionsmodul in der Lage ist, ein Datensignal auf dem dritten Testpfad korrekt zu empfangen; und

Bestimmen (S220) der Einrichtungszeit der Zeitsteuerungseinheit gemäß dem ersten Zeitraumwert, dem zweiten Zeitraumwert und dem dritten Zeitraumwert.

2. Verfahren zum Messen der Einrichtungszeit einer Zeitsteuerungseinheit nach Anspruch 1, wobei die Einrichtungszeit der Zeitsteuerungseinheit gleich einer Differenz ist, die durch eine Summe des ersten Zeitraumwerts und des dritten Zeitraumwerts minus des zweiten Zeitraumwerts erhalten wird.

3. Verfahren zum Messen der Einrichtungszeit einer Zeitsteuerungseinheit nach Anspruch 1, wobei das Bestimmen des ersten Zeitraumwerts, des zweiten Zeitraumwerts oder des dritten Zeitraumwerts des Taktsignals Folgendes umfasst:

Bestimmen (S310) von N kritischen Zeitraumtestwerten; und
Berechnen (S320) eines arithmetischen Mittelwerts der N kritischen Zeitraumtestwerte.

4. Verfahren zum Messen der Einrichtungszeit einer Zeitsteuerungseinheit nach Anspruch 3, wobei das Bestimmen der N kritischen Zeitraumtestwerte Folgendes umfasst:

S1: Bestimmen (S410) einer geschätzten Reichweite des kritischen Zeitraums des Taktsignals;
S2: Bestimmen (S420) eines ersten Schritts;
S3: sequentielles Testen (S430), gemäß dem ersten Schritt, von einem rechten Intervallwert der geschätzten Reichweite des kritischen Zeitraums zu einem linken Intervallwert der geschätzten Reichweite des kritischen Zeitraums, bis die zu testende Zeitsteuerungseinheit oder das Verzögerungsdetektionsmodul in der Lage ist, das Datensignal korrekt zu erhalten, und Aufzeichnen eines aktuellen Zeitraumwerts des Taktsignals als einen ersten kritischen Zeitraumtestwert;
N-1-maliges Wiederholen (S440) der Vorgänge S1 bis S3, um einen zweiten kritischen Zeitraumtestwert, einen dritten kritischen Zeitraumtestwert bzw. einen N-ten kritischen Zeitraumtestwert zu erhalten.

5. Verfahren zum Messen der Einrichtungszeit einer Zeitsteuerungseinheit nach Anspruch 4, wobei das Bestimmen der geschätzten Reichweite des kritischen Zeitraums des Taktsignals Folgendes umfasst:

Erfassen (S510) eines erwarteten Werts des kritischen Zeitraums des Taktsignals;
Bestimmen (S520) eines Zeitraumschritts, wobei der Zeitraumschritt eine Vielzahl von voreingestellten Zeitfenstern umfasst; und
sequentielles Testen (S530) von klein nach groß gemäß dem Zeitraumschritt, bis ein Testwert eines kritischen Zeitraums des Taktsignals mit dem erwarteten Wert des kritischen Zeitraums zu einem ersten Zeitpunkt nicht übereinstimmt, Nehmen einer Differenz zwischen dem aktuellen Testwert und dem Zeitraumschritt als den linken Intervallwert der geschätzten Reichweite des kritischen Zeitraums und Nehmen einer Summe des aktuellen Testwerts und des Zeitraumschritts als den rechten Intervallwert der geschätzten Reichweite des kritischen Zeitraums.

6. Verfahren zum Messen der Einrichtungszeit einer Zeitsteuerungseinheit nach Anspruch 4, wobei der erste Schritt gemäß einer Zeitdauer, in der das Taktsignal gejittet wird, bestimmt wird.

7. Schaltkreis zum Messen der Einrichtungszeit einer Zeitsteuerungseinheit, umfassend ein Taktsignal-Erzeugungsmodul (110), ein erstes Auswahlmodul (120), ein zweites Auswahlmodul (130), ein Verzögerungsdetektionsmodul (140), ein Datensignal-Übertragungsmodul (150), ein Taktsignal-Übertragungsmodul (160), eine zu testende Zeitsteuerungseinheit (170) und ein Steuermodul (180),

wobei das Taktsignal-Erzeugungsmodul (110) jeweils mit dem ersten Auswahlmodul (120), dem Verzögerungsdetektionsmodul (140) und dem Steuermodul (180) verbunden ist; das Verzögerungsdetektionsmodul (140) jeweils mit dem ersten Auswahlmodul (120), dem zweiten Auswahlmodul (120) und dem Steuermodul (180) verbunden ist; das erste Auswahlmodul (120) jeweils mit dem Steuermodul (180), dem Datensignal-Übertragungsmodul (150) und dem Taktsignal-Übertragungsmodul (160) verbunden ist; das zweite Auswahlmodul (130) jeweils mit dem Steuermodul (180), dem Datensignal-Übertragungsmodul (150) und dem Taktsignal-Übertragungsmodul (160) verbunden ist; das Datensignal-Übertragungsmodul (150) jeweils mit der zu testenden Zeitsteuerungseinheit (170) und dem Steuermodul (180) verbunden ist; das Taktsignal-Übertragungsmodul (160) jeweils mit der zu testenden Zeitsteuerungseinheit (170) und dem Steuermodul (180) verbunden ist; und die zu testende Zeitsteuerungseinheit (170) mit dem Steuermodul (180) verbunden ist, das Steuermodul (180) konfiguriert ist, um das erste Auswahlmodul (120) und das zweite Auswahlmodul (130) zu steuern, um jeweils einen ersten Testpfad, einen zweiten Testpfad und einen dritten Testpfad zu bilden, um die Einrichtungszeit der Zeitsteuerungseinheit auf Basis des ersten Testpfads, des zweiten Testpfads und des dritten Testpfads zu bestimmen, wobei der erste Testpfad das Taktsignal-Erzeugungsmodul (110), das Datensignal-Übertragungsmodul (150), das Taktsignal-Übertragungsmodul (160), die zu testende Zeitsteuerungseinheit (170) und das Steuermodul (180) umfasst, der zweite Testpfad das Taktsignal-Erzeugungsmodul (110), das Verzögerungsdetektionsmodul (140), das Datensignal-Übertragungsmodul (150) und das Steuermodul (160) umfasst und der dritte Testpfad das Taktsignal-Erzeugungsmodul (110), das Verzögerungsdetektionsmodul (140), das Taktsignal-Übertragungsmodul (160) und das Steuermodul (180) umfasst.

8. Schaltkreis zum Messen der Einrichtungszeit einer Zeitsteuerungseinheit nach Anspruch 7, wobei das Taktsignal-Erzeugungsmodul (110) eine Takt-Frequenz-Modulationseinheit (111) und eine Takt-Impuls-Steuereinheit (112) umfasst, die Takt-Frequenz-Modulationseinheit (111) mit der Takt-Impuls-Steuereinheit (112) verbunden ist, die Takt-Impuls-Steuereinheit (112) jeweils mit dem Verzögerungsdetektionsmodul (140) und einem ersten Eingabeende (A1) des ersten Auswahlmoduls (120) verbunden ist und das Steuermodul (180) jeweils mit der Takt-Frequenz-Modulationseinheit (111) und der Takt-Impuls-Steuereinheit (112) verbunden ist.

9. Schaltkreis zum Messen der Einrichtungszeit einer Zeitsteuerungseinheit nach Anspruch 7, wobei das Verzögerungsdetektionsmodul (140) ein erstes Startregister (141) und ein Aufnahmeregister (142) umfasst, ein erstes Eingabeende des ersten Startregisters (141) mit dem Taktsignal-Erzeugungsmodul (110) verbunden ist, ein zweites Eingabeende des ersten Startregisters (141) mit einem externen Datensignal verbunden ist und ein Ausgabeende des ersten Startregisters (141) mit einem zweiten Eingabeende (A2) des ersten Auswahlmoduls (120) verbunden ist, ein erstes Eingabeende des Aufnahmeregisters (142) mit dem Taktsignal-Erzeugungsmodul (110) verbunden ist, ein zweites Eingabeende des Aufnahmeregisters (142) mit einem Ausgabeende des zweiten Auswahlmoduls (130) verbunden ist und ein Ausgabeende des Aufnahmeregisters (142) mit dem Steuermodul (180) verbunden ist.

10. Schaltkreis zum Messen der Einrichtungszeit einer Zeitsteuerungseinheit nach Anspruch 7, wobei das Datensignal-Übertragungsmodul (150) ein zweites Startregister (151) umfasst, ein erstes Eingabeende des zweiten Startregisters (151) mit dem Ausgabeende des ersten Auswahlmoduls (120) verbunden ist, ein zweites Eingabeende des zweiten Startregisters (151) mit einem externen Datensignal verbunden ist und ein Ausgabeende des zweiten Startregisters (151) jeweils mit einem zweiten Eingabeende (B2) des zweiten Auswahlmoduls (130) und einem zweiten Eingabeende der zu testenden Zeitsteuerungseinheit (170) verbunden ist.

11. Schaltkreis zum Messen der Einrichtungszeit einer Zeitsteuerungseinheit nach Anspruch 10, wobei das Datensignal-Übertragungsmodul (150) ferner ein erstes Puffermodul (b1) umfasst, ein Eingabeende des ersten Puffermoduls (b1) mit dem Ausgabeende des zweiten Startregisters (151) verbunden ist und ein Ausgabeende des ersten Puffermoduls (b1) jeweils mit dem zweiten Eingabeende (B2) des zweiten Auswahlmoduls (130) und dem zweiten Eingabeende der zu testenden Zeitsteuerungseinheit (170) verbunden ist.

12. Schaltkreis zum Messen der Einrichtungszeit einer Zeitsteuerungseinheit nach Anspruch 7, wobei das Taktsignal-Übertragungsmodul (160) ein zweites Puffermodul (b2) umfasst, ein Eingabeende des zweiten Puffermoduls (b2) mit dem Ausgabeende des ersten Auswahlmoduls (120) verbunden ist und ein Ausgabeende des zweiten Puffermoduls (b2) jeweils mit einem ersten Eingabeende (B1) des zweiten Auswahlmoduls (130) und einem ersten Eingabeende der zu testenden Zeitsteuerungseinheit (170) verbunden ist.

13. Schaltkreis zum Messen der Einrichtungszeit einer Zeitsteuerungseinheit nach Anspruch 7, wobei

als Reaktion darauf, dass das Steuermodul (180) ein erstes Eingabeende (A1) des ersten Auswahlmoduls (120) steuert, um geschlossen zu werden, und ein zweites Eingabeende (A2) steuert, um geöffnet zu werden, und ein erstes Eingabeende (B1) und ein zweites Eingabeende (B2) des zweiten Auswahlmoduls (130) steuern, um beide geöffnet zu werden, der erste Testpfad gebildet wird;
als Reaktion darauf, dass das Steuermodul (180) das erste Eingabeende (A1) des ersten Auswahlmoduls (120) steuert, um geöffnet zu werden, und das zweite Eingabeende (A2) steuert, um geschlossen zu werden, und das erste Eingabeende (B1) des zweiten Auswahlmoduls (130) steuert, um geöffnet zu werden, und das zweite Eingabeende (B2) steuert, um geschlossen zu werden, der zweite Testpfad gebildet wird; und

als Reaktion darauf, dass das Steuermodul (180) das erste Eingabeende (A1) des ersten Auswahlmoduls (120) steuert, um geöffnet zu werden, und das zweite Eingabeende (A2) steuert, um geschlossen zu werden, und das erste Eingabeende (B1) des zweiten Auswahlmoduls (130) steuert, um geschlossen zu werden, und das zweite Eingabeende (B2) steuert, um geöffnet zu werden, der dritte Testpfad gebildet wird.

**Revendications**

1. Procédé pour mesurer un temps de configuration d'une unité de synchronisation, qui est applicable à un circuit pour mesurer un temps de configuration d'une unité de synchronisation, dans lequel le circuit comprend un module de génération de signaux d'horloge (110), un premier module de sélection (120), un deuxième module de sélection (130), un module de détection de retard (140), un module de transmission de signaux de données (150), un module de transmission de signaux d'horloge (160), une unité de synchronisation à tester (170) et un module de contrôle (180), le module de contrôle contrôle le premier module de sélection et le deuxième module de sélection pour former un premier chemin de test, un deuxième chemin de test et un troisième chemin de test, respectivement, le premier chemin de test comprend le module de génération de signaux d'horloge, le module de transmission de signaux de données, le module de transmission de signaux d'horloge, l'unité de synchronisation à tester et le module de contrôle, le deuxième chemin de test comprend le module de génération de signaux d'horloge, le module de détection de retard, le module de transmission de signaux de données et le module de contrôle, et le troisième chemin de test comprend le module de génération de signaux d'horloge, le module de détection de retard, le module de transmission de signaux d'horloge et le module de contrôle ; et
le procédé comprend :

   déterminer respectivement (S210) une première valeur de période, une deuxième valeur de période et une troisième valeur de période d'un signal d'horloge, dans lequel la première valeur de période est une période critique du signal d'horloge lorsque l'unité de synchronisation à tester est capable de recevoir correctement un signal de données au niveau du premier chemin de test, la deuxième valeur de période est une période critique du signal d'horloge lorsque le module de détection de retard est capable de recevoir correctement un signal de données au niveau du deuxième chemin de test, et la troisième valeur de période est une période critique du signal d'horloge lorsque le module de détection de retard est capable de recevoir correctement un signal de données au niveau du troisième chemin de test ; et
   déterminer (S220) le temps de configuration de l'unité de synchronisation selon la première valeur de période, la deuxième valeur de période et la troisième valeur de période.

2. Procédé pour mesurer un temps de configuration d'une unité de synchronisation selon la revendication 1, dans lequel le temps de configuration de l'unité de synchronisation est égal à une différence obtenue par une somme de la première valeur de période et de la troisième valeur de période moins la deuxième valeur de période.

3. Procédé pour mesurer un temps de configuration d'une unité de synchronisation selon la revendication 1, dans lequel déterminer une quelconque de la première valeur de période, de la deuxième valeur de période ou de la troisième valeur de période du signal d'horloge comprend :

   déterminer (S310) N valeurs de test de période critiques ; et
   calculer (S320) une valeur moyenne arithmétique des N valeurs de test de période critiques.

4. Procédé pour mesurer un temps de configuration d'une unité de synchronisation selon la revendication 3, dans lequel déterminer les N valeurs de test de période critiques comprend :

   S1 : déterminer (S410) une plage estimée de la période critique du signal d'horloge ;
   S2 : déterminer (S420) une première étape ;
   S3 : tester séquentiellement (S430), selon la première étape, d'une valeur d'intervalle droit de la plage estimée de la période critique à une valeur d'intervalle gauche de la plage estimée de la période critique, jusqu'à ce que l'unité de synchronisation à tester ou le module de détection de retard soit capable d'obtenir correctement le signal de données, et enregistrer une valeur de période courante du signal d'horloge en tant que première valeur de test de période critique ;
   répéter (S440) les opérations S1 à S3 pendant N-1 fois pour obtenir une deuxième valeur de test de période critique, une troisième valeur de test de période critique, ... une Nième valeur de test de période critique, respectivement.

**5.** Procédé pour mesurer un temps de configuration d'une unité de synchronisation selon la revendication 4, dans lequel déterminer la plage estimée de la période critique du signal d'horloge comprend :

acquérir (S510) une valeur attendue de la période critique du signal d'horloge ;
déterminer (S520) une étape de période, dans lequel l'étape de période comprend une pluralité de fenêtres temporelles prédéfinies ; et
tester séquentiellement (S530) de petit à grand selon l'étape de période, jusqu'à ce qu'une valeur de test d'une période critique du signal d'horloge soit incompatible avec la valeur attendue de la période critique pour une première fois, prendre une différence entre la valeur de test courante et l'étape de période en tant que valeur d'intervalle gauche de la plage estimée de la période critique, et prendre une somme de la valeur de test courante et de l'étape de période en tant que valeur d'intervalle droit de la plage estimée de la période critique.

**6.** Procédé pour mesurer un temps de configuration d'une unité de synchronisation selon la revendication 4, dans lequel la première étape est déterminée selon une durée pendant laquelle le signal d'horloge est gratté.

**7.** Circuit pour mesurer un temps de configuration d'une unité de synchronisation, comprenant un module de génération de signaux d'horloge (110), un premier module de sélection (120), un deuxième module de sélection (130), un module de détection de retard (140), un module de transmission de signaux de données (150), un module de transmission de signaux d'horloge (160), une unité de synchronisation à tester (170) et un module de contrôle (180),

dans lequel le module de génération de signaux d'horloge (110) est respectivement connecté au premier module de sélection (120), au module de détection de retard (140) et au module de contrôle (180) ; le module de détection de retard (140) est respectivement connecté au premier module de sélection (120), au deuxième module de sélection (120) et au module de contrôle (180) ; le premier module de sélection (120) est respectivement connecté au module de contrôle (180), au module de transmission de signaux de données (150) et au module de transmission de signaux d'horloge (160) ; le deuxième module de sélection (130) est respectivement connecté au module de contrôle (180), au module de transmission de signaux de données (150) et au module de transmission de signaux d'horloge (160) ; le module de transmission de signaux de données (150) est respectivement connecté à l'unité de synchronisation à tester (170) et au module de contrôle (180) ; le module de transmission de signaux d'horloge (160) est respectivement connecté à l'unité de synchronisation à tester (170) et au module de contrôle (180) ; et l'unité de synchronisation à tester (170) est connectée au module de contrôle (180),
le module de contrôle (180) est configuré pour contrôler le premier module de sélection (120) et le deuxième module de sélection (130) pour former un premier chemin de test, un deuxième chemin de test et un troisième chemin de test, respectivement, de manière à déterminer le temps de configuration de l'unité de synchronisation sur la base du premier chemin de test, du deuxième chemin de test et du troisième chemin de test,
dans lequel le premier chemin de test comprend le module de génération de signaux d'horloge (110), le module de transmission de signaux de données (150), le module de transmission de signaux d'horloge (160), l'unité de synchronisation à tester (170) et le module de contrôle (180), le deuxième chemin de test comprend le module de génération de signaux d'horloge (110), le module de détection de retard (140), le module de transmission de signaux de données (150) et le module de contrôle (160), et le troisième chemin de test comprend le module de génération de signaux d'horloge (110), le module de détection de retard (140), le module de transmission de signaux d'horloge (160) et le module de contrôle (180).

**8.** Circuit pour mesurer un temps de configuration d'une unité de synchronisation selon la revendication 7, dans lequel le module de génération de signaux d'horloge (110) comprend une unité de modulation de fréquence d'horloge (111) et une unité de contrôle d'impulsion d'horloge (112), l'unité de modulation de fréquence d'horloge (111) est connectée à l'unité de contrôle d'impulsion d'horloge (112), l'unité de contrôle d'impulsion d'horloge (112) est respectivement connectée au module de détection de retard (140) et à une première extrémité d'entrée (A1) du premier module de sélection (120), et le module de contrôle (180) est respectivement connecté à l'unité de modulation de fréquence d'horloge (111) et à l'unité de contrôle d'impulsion d'horloge (112).

**9.** Circuit pour mesurer un temps de configuration d'une unité de synchronisation selon la revendication 7, dans lequel le module de détection de retard (140) comprend un premier registre de lancement (141) et un registre de capture (142), une première extrémité d'entrée du premier registre de lancement (141) est connectée au module de génération de signaux d'horloge (110), une deuxième extrémité d'entrée du premier registre de lancement (141) est connectée à un signal de données externe, et une extrémité de sortie du premier registre de lancement (141) est connectée à une deuxième extrémité d'entrée (A2) du premier module de sélection (120),

une première extrémité d'entrée du registre de capture (142) est connectée au module de génération de signaux d'horloge (110), une deuxième extrémité d'entrée du registre de capture (142) est connectée à une extrémité de sortie du deuxième module de sélection (130), et une extrémité de sortie du registre de capture (142) est connectée au module de contrôle (180).

10. Circuit pour mesurer un temps de configuration d'une unité de synchronisation selon la revendication 7, dans lequel le module de transmission de signaux de données (150) comprend un deuxième registre de lancement (151), une première extrémité d'entrée du deuxième registre de lancement (151) est connectée à l'extrémité de sortie du premier module de sélection (120), une deuxième extrémité d'entrée du deuxième registre de lancement (151) est connectée à un signal de données externe, et une extrémité de sortie du deuxième registre de lancement (151) est respectivement connectée à une deuxième extrémité d'entrée (B2) du deuxième module de sélection (130) et à une deuxième extrémité d'entrée de l'unité de synchronisation à tester (170).

11. Circuit pour mesurer un temps de configuration d'une unité de synchronisation selon la revendication 10, dans lequel le module de transmission de signaux de données (150) comprend en outre un premier module tampon (b1), une extrémité d'entrée du premier module tampon (b1) est connectée à l'extrémité de sortie du deuxième registre de lancement (151), et une extrémité de sortie du premier module tampon (b1) est respectivement connectée à la deuxième extrémité d'entrée (B2) du deuxième module de sélection (130) et à la deuxième extrémité d'entrée de l'unité de synchronisation à tester (170).

12. Circuit pour mesurer un temps de configuration d'une unité de synchronisation selon la revendication 7, dans lequel le module de transmission de signaux d'horloge (160) comprend un deuxième module tampon (b2), une extrémité d'entrée du deuxième module tampon (b2) est connectée à l'extrémité de sortie du premier module de sélection (120), et une extrémité de sortie du deuxième module tampon (b2) est respectivement connectée à une première extrémité d'entrée (B1) du deuxième module de sélection (130) et à une première extrémité d'entrée de l'unité de synchronisation à tester (170).

13. Circuit pour mesurer un temps de configuration d'une unité de synchronisation selon la revendication 7, dans lequel

en réponse au fait que le module de contrôle (180) contrôle une première extrémité d'entrée (A1) du premier module de sélection (120) pour qu'elle soit fermée et une deuxième extrémité d'entrée (A2) pour qu'elle soit ouverte, et une première extrémité d'entrée (B1) et une deuxième extrémité d'entrée (B2) du deuxième module de sélection (130) pour qu'elles soient toutes deux ouvertes, le premier chemin de test est formé ;
en réponse au fait que le module de contrôle (180) contrôle la première extrémité d'entrée (A1) du premier module de sélection (120) pour qu'elle soit ouverte et la deuxième extrémité d'entrée (A2) pour qu'elle soit fermée, et la première extrémité d'entrée (B1) du deuxième module de sélection (130) pour qu'elle soit ouverte et la deuxième extrémité d'entrée (B2) pour qu'elle soit fermée, le deuxième chemin de test est formé ; et
en réponse au fait que le module de contrôle (180) contrôle la première extrémité d'entrée (A1) du premier module de sélection (120) pour qu'elle soit ouverte et la deuxième extrémité d'entrée (A2) pour qu'elle soit fermée, et la première extrémité d'entrée (B1) du deuxième module de sélection (130) pour qu'elle soit fermée et la deuxième extrémité d'entrée (B2) pour qu'elle soit ouverte, le troisième chemin de test est formé.

Data signal

tsu

Clock signal

FIG. 1

140 Delay detection module

130 Second selection module

150 Data signal transmission module

110 Clock signal generation module

120 First selection module

170 Timing unit to be tested

160 Clock signal transmission module

180 Control module

FIG. 2

FIG. 3

Respectively determine a first period value, a second period value and a third period value of a clock signal, the first period value is a critical period of the clock signal when a timing unit to be tested is capable of correctly receiving a data signal at a first test path, the second period value is a critical period of the clock signal when a delay detection module is capable of correctly receiving a data signal at a second test path, and the third period value is a critical period of the clock signal when the delay detection module is capable of correctly receiving a data signal at a third test path

S210

Determine a setup time of the timing unit according to the first period value, the second period value and the third period value

S220

FIG. 4

Determine N critical period test values     S310

Calculate an arithmetic mean value of the N critical period test values     S320

FIG. 5

Determine an estimated range of the critical period of the clock signal     S410

Determine a first step     S420

Sequentially test, according to the first step, from a right interval value of the estimated range of the critical period to a left interval value of the estimated range of the critical period, until the timing unit to be tested or the delay detection module is capable of correctly obtaining an external data signal, and record a current period value of the clock signal as a first critical period test value     S430

Repeat operations S410 to S430 for N-1 times to obtain a second critical period test value, a third critical period test value, ... an $N^{th}$ critical period test value, respectively     S440

FIG. 6

Acquire an expected value of the critical period of the clock signal — S510

Determine a period step, the period step includes a plurality of preset time windows — S520

Sequentially test from small to large according to the period step, until a test value of the critical period of the clock signal is inconsistent with the expected value of the critical period for a first time, take a difference between a current test value and the period step as the left interval value of the estimated range of the critical period, and take a sum of the current test value and the period step as the right interval value of the estimated range of the critical period — S530

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2001014851 A1